# EUROPÄISCHE PATENTSCHRIFT

(11) **EP 2 705 549 B1**
(45) Veröffentlichungstag und Bekanntmachung des Hinweises auf die Patenterteilung: **26.08.2015**
(21) Anmeldenummer: 12718248.3
(22) Anmeldetag: 04.05.2012
(51) Int. Cl.: H01L 41/45, H01L 41/083, H01L 41/09, H01L 41/193, H01L 41/257

(54) **ELEKTROMECHANISCHE WANDLEREINRICHTUNG**
ELECTROMECHANICAL TRANSDUCER DEVICE
DISPOSITIF CONVERTISSEUR ÉLECTROMÉCANIQUE

(30) Priorität: 06.05.2011 EP 11165075
(43) Veröffentlichungstag der Anmeldung: 12.03.2014
(73) Patentinhaber: Universität Potsdam, 14469 Potsdam (DE)
(72) Erfinder: GERHARD, Reimund, 10623 Berlin (DE); WIRGES, Werner, 14532 Kleinmachnow (DE); RYCHKOV, Dmitry, 14469 Potsdam (DE); JENNINGER, Werner, verstorben (DE)
(74) Vertreter: Schubert, Klemens
(86) Internationale Anmeldenummer: PCT/EP2012/058230
(87) Internationale Veröffentlichungsnummer: WO 2012/152684

(56) Entgegenhaltungen:
- WO-A1-2007/029275
- MAZUR: "Piezoelectricity of PVDF/PUE, PVDF/PMMA and PVDF/PMMA+BaTiO3 Laminates", IEEE TRANSACTIONS ON ELECTRICAL INSULATION, Bd. 27, Nr. 4, 1. Januar 1992 (1992-01-01) , Seite 782, XP055004424, ISSN: 0018-9367, DOI: 10.1109/14.155798
- GERHARD-MULTHAUPT R ET AL: "Preliminary study of multi-layer space-charge electrets with piezoelectric properties from porous and non-porous Teflon films", ELECTRETS, 1999. ISE 10. PROCEEDINGS. 10TH INTERNATIONAL SYMPOSIUM ON ATHENS, GREECE 22-24 SEPT. 1999, PISCATAWAY, NJ, USA,IEEE, US, 22. September 1999 (1999-09-22), Seiten 273-276, XP010376541, DOI: 10.1109/ISE.1999.832040 ISBN: 978-0-7803-5025-0

## Beschreibung

Die Erfindung betrifft eine elektromechanische Wandlereinrichtung umfassend einen zwischen einer ersten Elektrode und mindestens einer zweiten Elektrode angeordneten Schichtverbund. Darüber hinaus betrifft die Erfindung ein elektromechanisches Wandlersystem, eine Aktorvorrichtung, eine Generatoreinrichtung und ein Verfahren zum Herstellen einer elektromechanischen Wandlereinrichtung.

Kunststoffverbundstoffe werden in einer Vielzahl von Anwendungen eingesetzt. Beispielsweise wird ein entsprechender Schichtverbund als Verpackungsmaterial, Isolationsmaterial oder als Konstruktionsmaterial verwendet. Neben diesem herkömmlichen Einsatzzweck werden Schichtverbunde vermehrt als aktive Komponenten in Generatoranwendungen, Sensoranwendungen oder Aktoranwendungen eingesetzt.

Derartige Schichtverbunde weisen im Allgemeinen mindestens eine elektroaktive Schicht auf, wie eine dielektrische Elastomerschicht. Um eine elektromechanische Wandlereinrichtung zu erhalten, kann eine elektroaktive Schicht beidseitig mit jeweils einer elektrisch leitfähigen Schicht beschichtet sein. Die beiden elektrisch leitfähigen Schichten können als Elektroden dienen. Wird an den Elektroden ein elektrisches Signal, beispielsweise eine Spannung angelegt, dehnt sich die dielektrische Elastomerschicht aus. Insbesondere kann eine Dehnung in Abhängigkeit einer Spannung, welche zwischen 0 V als untere Grenze und einer Durchbruchspannung als obere Grenze liegen kann, erzeugt werden. Umgekehrt kann bei einer mechanischen Einwirkung auf den Schichtverbund ein elektrisches Signal, insbesondere eine Spannung, an den Elektroden abgegriffen werden, sofern gleichzeitig eine elektrische Spannung anliegt.

Nachteilig bei derartigen elektromechanischen Wandlereinrichtungen ist es, dass für eine ausreichende Aktorik, also um eine ausreichend hohe Dehnung der elektroaktiven Schicht zu erzielen, an die Elektroden Spannungen im Bereich von 1000 V angelegt werden müssen. Um bei generatorischen Anwendungen eine hohe Energiemenge zu gewinnen, müssen ähnlich hohe Spannungen angelegt werden. Derart hohe Spannungsänderungen limitieren einen ökonomischen und effizienten Einsatz von elektroaktiven Schichten bzw. von elektromechanischen Wandlereinrichtungen umfassend zumindest einen Schichtverbund mit einer elektroaktiven Schicht jedoch erheblich.

Nach dem Stand der Technik bekannte Vorrichtungen werden in WO 2007 7 029275 A1; Karol Mazur, "Piezoelectricity of PVDF/PUE, PVDF/PMMA and PVDF/PMMA+BaTiO3 Laminates", IEEE Transactions on Electrical Insulation, vol. 27, No. 4, S. 782-786, (1992) sowie R. Gerhard-Multhaupt et al., "Preliminary study of multi-layer space-charge electrets with piezoelectric properties from porous an non-porous Teflon films", Proceedings 10th International Symposium on Electrets, Athens, Greece, 22-24 September 1999, ISBN 978-0-7803-5025-0, S. 273-276, (1999) beschrieben.

Daher liegt der vorliegenden Erfindung die Aufgabe zugrunde, eine elektromechanische Wandlereinrichtung zur Verfügung zu stellen, welche ökonomischer und insbesondere effizienter betrieben werden kann.

Die zuvor hergeleitete und aufgezeigte Aufgabe wird gemäß einem ersten Aspekt der Erfindung bei einer elektromechanischen Wandlereinrichtung gemäß Anspruch 1 und ein dazu gehöriges Herstellungsverfahren gemäß Anspruch 13 gelöst.

Im Gegensatz zum Stand der Technik wird gemäß der Lehre der Erfindung eine elektromechanische Wandlereinrichtung zur Verfügung gestellt, welche ökonomischer und insbesondere effizienter betrieben werden kann, indem zwischen zwei elektroaktiven Schichten ein Elektretmaterial mit einer vorgebbaren Ladung angeordnet ist.

Die elektromechanische Wandlereinrichtung umfasst mindestens einen Schichtverbund, dessen äußere Oberflächen mit jeweils einer Elektrode bevorzugt unmittelbar kontaktiert, beispielsweise beschichtet, sind. An der Oberseite des Schichtverbunds kann eine elektrisch leitfähige Schicht angeordnet sein. Ebenso kann an der Unterseite des Schichtverbunds eine elektrisch leitfähige Schicht angeordnet sein. Es versteht sich, dass die Unterseite bzw. die Oberseite nur teilweise bzw. abschnittsweise mit einer elektrisch leitfähigen Schicht beschichtet sein kann. Beispielsweise kann eine strukturierte bzw. segmentierte Schicht gebildet werden. Vorzugsweise kann eine elektrisch leitfähige Schicht aus einem Material gebildet sein, das ausgewählt ist aus der Gruppe umfassend Metalle, Metalllegierungen, leitfähige Oligo- oder Polymere, leitfähige Oxide, Kohlenstoffnanoröhrchen und/oder mit leitfähigen Füllstoffen gefüllte Polymere.

Der Schichtverbund umfasst mindestens zwei elektroaktive Schichten. Insbesondere können eine obere elektroaktive Schicht und eine untere elektroaktive Schicht vorgesehen sein. Die beiden äußeren Oberflächen der zwei elektroaktiven Schichten können die äußeren Oberflächen des Schichtverbunds bilden, welche mit jeweils einer Elektrode kontaktiert sein können.

Zwischen der ersten elektroaktiven Schicht und der zweiten elektroaktiven Schicht ist ein Elektretmaterial zumindest abschnittsweise vorhanden. Bevorzugt kann das Elektretmaterial flächig mit der ersten elektroaktiven Schicht und/oder der zweiten elektroaktiven Schicht verbunden sein. Mit anderen Worten kann das Elektretmaterial die erste elektroaktive Schicht und die zweite elektroaktive Schicht bevorzugt direkt kontaktieren. Es ist insbesondere keine elektrisch leitfähige Schicht zwischen dem Elektretmaterial und einer elektroaktiven Schicht vorgesehen.

Ein Elektretmaterial weist den Vorteil auf, dass elektrische Ladungen in dem Elektret (permanent) gespeichert werden können. Die vorgebbare elektrische Ladung kann beispielsweise durch eine elektrische Aufladung des Elektretmaterials erzeugt werden. Ein Elektretmaterial kann positiv oder negativ aufgeladen sein, also positive oder negative Ladungen aufweisen. Die Ladungsart und/oder die Ladungshöhe können insbesondere an eine Anwendung der elektroaktiven Wandlereinrichtung angepasst sein. Beispielsweise kann die Elektretschicht eine Oberflächenladungsdichte aufweisen, die eine Spannung zwischen Elektretschicht und benachbarter Elektrode von 100 bis 2000 V erzeugt.

Durch die Anordnung von einem Elektretmaterial in dem Schichtverbund, welches eine permanente elektrische Ladung aufweist, wird der Vorteil erzielt, dass die an die Elektrode anzulegende Spannung zur Erzielung einer bestimmten Dehnung im Vergleich zum Stand der Technik deutlich geringer ist. Es ist insbesondere erkannt worden, dass der Effekt, wonach zwischen einem an einer elektroaktiven Schicht angelegten elektrischen Feld und der Dehnung der elektroaktiven Schicht ein näherungsweise quadratischer Zusammenhang besteht, für eine Vielzahl an Anwendungen in vorteilhafter Weise genutzt werden kann. So sind die Dehnungsänderungen bei Spannungsänderungen in einem niedrigen Spannungsbereich gering, während die Dehnungsänderungen bei einer gleichen Spannungsänderung im hohen Spannungsbereich groß sind. Es versteht sich, dass die vorherige Ausführung auch sinngemäß für eine generatorische Anwendung gilt.

Gemäß einer ersten Ausführungsform der erfindungsgemäßen elektromechanischen Wandlereinrichtung kann in Abhängigkeit der elektrischen Ladung des Elektretmaterials ein Arbeitspunkt der elektromechanischen Wandlereinrichtung einstellbar sein. Wie bereits beschrieben wurde, besteht zwischen der Dehnung einer elektroaktiven Schicht und dem anliegenden elektrischen Feld, bzw. der Spannung ein näherungsweise quadratischer Zusammenhang. Grundsätzlich kann die Dehnung zwischen einem Minimalwert, der sich ergibt, wenn kein elektrisches Feld anliegt, und einem Maximalwert, der durch die Durchbruchsfeldstärke bestimmt wird, eingestellt werden. Durch Einbringen eines eine vorgebbare elektrische Ladung aufweisenden Elektretmaterials kann der Arbeitspunkt von dem Nullpunkt verschoben werden. Der Vorteil einer Verschiebung des Arbeitspunkts liegt darin, dass die für eine bestimmte Dehnungsänderung erforderliche Spannungsänderung deutlich reduziert werden kann. Bevorzugt kann der Arbeitspunkt durch Einbringen einer permanenten Ladung derart geändert werden, dass bereits Spannungsänderungen von 100 V, insbesondere von 10 V, eine ausreichende Dehnungsänderungen bewirken. Eine ausreichende Dehnungsänderung, die von der Anwendung abhängen kann, ist insbesondere eine Dehnung von zumindest 0,1 bis 35 %.

Grundsätzlich kann das Elektretmaterial in beliebiger Form bereitgestellt werden. Gemäß einer Ausführungsform kann das Elektretmaterial aus Elektretfasern, Elektretkugeln oder einer Elektretschicht gebildet sein. Es kann also eine Zwischenregion aus Elektretfasern oder Elektretkugeln vorgesehen sein. Bevorzugt kann eine Elektretschicht vorgesehen sein, da diese leicht herzustellen ist und eine gleichmäßige Ladungsverteilung über die vorzugsweise gesamte Fläche aufweist.

Vorteilhafterweise kann gemäß einer weiteren Ausführungsform der erfindungsgemäßen elektromechanische Wandlereinrichtung das Elektretmaterial ein Material umfassen, das ausgewählt ist aus der Gruppe umfassend Polycarbonat, perfluorierte oder teilfluorierte Polymere und Co-Polymere, Polytetrafluorethylen, Fluorethylenpropylen, Perfluoralkoxyethylen, Polyester, Polyethylenterephthalat, Polyethylennaphthalat, Polyimin, Polyetherimid, Polyether und Polyetherblends (PPE/PS), Polymethyl(meth)acrylat, Cyclo-Olefin-Polymere, Cyclo-Olefin-Copolymere und/oder Polyolefine.

Gemäß einer Ausführungsform der elektromechanischen Wandlereinrichtung der vorliegenden Erfindung ist mindestens eine elektroaktive Schicht eine dielektrische Elastomerschicht. Insbesondere kann die dielektrische Elastomerschicht eine dielektrische Elastomerfolie sein. Eine dielektrische Elastomerschicht weist vorzugsweise eine relativ hohe Dielektrizitätszahl auf. Darüber hinaus weist eine dielektrische Elastomerschicht vorzugsweise eine niedrige mechanische Steifigkeit auf. Diese Eigenschaften führen zu möglichen Dehnungswerten von bis zu ca. 300 %. Eine dielektrische Elastomerschicht kann insbesondere für eine Aktoranwendung eingesetzt werden. Jedoch eignen sich dielektrische Elastomerschicht ebenso für Sensor- oder Generatoranwendungen. Bevorzugt sind die beiden elektroaktiven Schichten aus dem gleichen Material gebildet.

Ferner kann die dielektrische Elastomerschicht gemäß einer bevorzugten Ausführungsform der Erfindung ein Material umfassen, das beispielsweise ausgewählt ist aus der Gruppe umfassend Polyurethan-Elastomere, Silikon-Elastomere, Kautschuk-Elastomere (natural rubber and various copolymers) und/oder Acrylat-Elastomere.

Die erste elektroaktive Schicht und die zweite elektroaktive Schicht können bevorzugt aus dem gleichen Material gebildet sein. Insbesondere können die sich gegenüberliegenden Schichten auch die gleiche Form, vorzugsweise gleiche Dimensionen, haben. Gemäß einer weiteren Ausführungsform kann die erste elektroaktive Schicht einen ersten Dickenverlauf aufweisen. Die zweite elektroaktive Schicht kann einen zweiten Dickenverlauf aufweisen. Insbesondere kann der erste Dickenverlauf im Wesentlichen gleich dem zweiten Dickenverlauf sein. Durch einen gleichen Dickenverlauf kann jeweils ein gleich starkes elektrisches Feld zwischen der ersten Elektrode und dem Elektretmaterial und der zweiten Elektrode und dem Elektretmaterial erzeugt werden. Grund hierfür ist, dass das elektrische Feld unmittelbar von der Dicke des Zwischenmaterials abhängt.

Eine elektroaktive Schicht kann sich zumindest in eine Richtung ausdehnen. Bei einer dielektrischen Elastomerschicht kann das Volumen der Schicht in Folge einer Beaufschlagung mit einem elektrischen Feld im Wesentlichen konstant bleiben. Beispielsweise kann sich bei einem konstanten Volumen die Dicke verringern und gleichzeitig die Fläche vergrößern. Bei einer Ferroelektretfolie kann sich im Wesentlichen (lediglich) die Dicke der Schicht ändern. Die Dehnfähigkeit der elektroaktiven Schichten kann jedoch durch weitere Schichten, die die elektroaktiven Schichten kontaktieren, beschränkt sein. Um beispielsweise bei einer dielektrischen Schicht eine Ausdehnung nicht nur in Dickenrichtung, sondern auch in eine Längsrichtung und/oder in eine Querrichtung zu ermöglichen, kann es erforderlich sein, dass das Elektretmaterial und/oder die Elektroden dehnfähig ausgebildet sind. Beispielsweise können entsprechend nachgiebige Materialien eingesetzt werden, also Materialien, welche eine geringe Steifigkeit aufweisen. Beispielhafte nachgiebige Materialien sind mit elektrisch leitfähigen Füllstoffen gefüllte Elastomere oder Fluorethylenpropylene.

Um auch steife Materialien einsetzen zu können, kann vorteilhafterweise gemäß einer Ausführungsform der erfindungsgemäßen elektromechanischen Wandlereinrichtung die mindestens eine Elektretschicht ein wellenförmiges Querschnittsprofil aufweisen. Alternativ oder zusätzlich kann mindestens eine Elektrode ein wellenförmiges Querschnittsprofil aufweisen. Eine Schicht kann insbesondere entlang wenigstens einer Richtung ein wellenförmiges Querschnittsprofil aufweisen. Ein wellenförmiges Querschnittsprofil weist Erhebungen und Senkungen auf, welche bevorzugt in einer im Wesentlichen gleichmäßigen Abfolge angeordnet sein können. Es versteht sich, dass auch andere Abfolgen vorgesehen sein können, die sich insbesondere an der späteren Anwendung orientieren können. Bei einer Dehnung wird das wellenförmige Querschnittsprofil gestreckt und so eine Dehnfähigkeit in mindestens eine Richtung erhöht.

Gemäß einer weiteren Ausführungsform kann eine Energiequelle zwischen der ersten Elektrode und der zweiten Elektrode der elektromechanischen Wandlereinrichtung geschaltet sein. Die Energiequelle kann steuerbar ausgebildet sein. Insbesondere kann die Energiequelle, beispielsweise eine Spannungsquelle, dazu eingerichtet sein, eine Spannungsdifferenz zwischen den beiden angeschlossenen Elektroden zu erzeugen. Durch eine Spannungsdifferenz wird eine der mindestens zwei elektroaktiven Schichten stärker gedehnt, als die andere der mindestens zwei elektroaktiven Schichten. Mit anderen Worten wird eine Biegung der elektromechanischen Wandlereinrichtung erzeugt. Ein Biegewandler kann in einfacher Weise zur Verfügung gestellt werden. Beispielsweise kann durch eine Spannungsdifferenz im Bereich von 100 V und weniger aus einer flächigen Form der Wandlereinrichtung eine Halbkreisform erzeugt werden. Eine asymmetrische elektromechanische Wandlereinrichtung kann bereitgestellt werden. In einer weiteren beispielhaften Ausführung kann die elektromechanische Wandlereinrichtung als Diaphragma ausgebildet sein. Eine taktile Rückmeldung kann beispielsweise erzeugt werden. Vorzugsweise ist in diesem Fall die äußere Elektrode geerdet.

In einer weiteren Ausführungsform der erfindungsgemäßen Wandlereinrichtung kann die elektromechanische Wandlereinrichtung derart ausgebildet sein, dass ein symmetrischer Betrieb der elektromechanischen Wandlereinrichtung möglich ist. Im Gegensatz zur vorherigen Ausführungsform können die erste und die zweite Elektrode mit dem gleichen Spannungswert beaufschlagt werden. Mit anderen Worten können die beiden Elektroden (jederzeit) auf dem gleichen Potential liegen. Beispielsweise können zwei steuerbare Energiequellen vorgesehen sein. In einfacher Weise kann durch Anlegen einer geringen Spannung im Bereich von 100 V, bevorzugt im Bereich von 10 V, eine ausreichende Aktorik erzielt werden.

Grundsätzlich können zwei oder mehr zuvor beschriebene Schichtverbunde zu einem Stapel kaskadiert werden. Vorzugsweise kann zwischen jedem Schichtverbund zumindest eine Elektrode vorgesehen sein. Ferner kann zumindest an den äußeren Flächen der kaskadierten Schichtverbunde jeweils eine Elektrode vorgesehen sein.

Gemäß einer bevorzugten Ausführungsform kann mindestens ein weiterer mit einer weiteren Elektrode versehener Schichtverbund vorgesehen sein. Der weitere Schichtverbund kann eine erste elektroaktive Schicht und mindestens eine zweite elektroaktive Schicht aufweisen. Beispielsweise können die elektroaktiven Schichten dielektrische Elastomerschichten sein. Zwischen der ersten elektroaktiven Schicht und der zweiten elektroaktiven Schicht kann zumindest abschnittsweise bzw. teilweise ein Elektretmaterial vorgesehen sein. Dieses kann die beiden elektroaktiven Schichten bevorzugt direkt kontaktieren. Beispielsweise kann das Elektretmaterial in Form von Elektretfasern, Elektretkugeln und/oder einer Elektretschicht angeordnet sein. Das Elektretmaterial kann eine vorgebbare elektrische Ladung aufweisen. Insbesondere kann das Elektretmaterial des weiteren Schichtverbunds die gleiche Polarität wie das Elektretmaterial des ersten Schichtverbunds aufweisen. Ferner können auch die Ladungsbeträge von beiden Elektretmaterialien im Wesentlichen gleich sein. Der weitere Schichtverbund kann mit der ersten Elektrode oder der zweiten Elektrode verbunden sein. In einfacher Weise kann eine Stapelung einer Mehrzahl an Schichtverbunden durchgeführt werden. Eine optimale Anpassung der elektromechanischen Wandlereinrichtung an eine spätere Anwendung ist möglich.

Es versteht sich, dass weitere Schichtverbunde und/oder Zwischenschichten zwischen den mindestens zwei Schichtverbunden vorgesehen sein können.

Bevorzugt können sämtliche Schichten einer elektroaktiven Wandlereinrichtung einen parallelen Schichtverlauf aufweisen. Insbesondere kann beispielsweise der Dickenverlauf sämtlicher elektroaktiver Schichten im Wesentlichen gleich sein. Auch kann der Verlauf einer ersten Elektretschicht im Wesentlichen dem Verlauf einer zweiten Elektretschicht entsprechen. In einer weiteren Ausführungsform der erfindungsgemäßen elektromechanischen Wandlereinrichtung kann eine erste Elektretschicht und mindestens eine weitere Elektretschicht bevorzugt entlang derselben Richtung ein wellenförmiges Querschnittsprofil mit Erhebungen und Vertiefungen aufweisen, wobei die Erhebungen und Vertiefungen der ersten Elektretschicht parallel zu den Erhebungen und Vertiefungen der mindestens einen weiteren Elektretschicht verlaufen. Dann kann auch bei einer großen Dehnung die Dicke der Elastomerschicht in der Verlaufsrichtung der Wellen möglichst einheitlich bleiben. Gleiches kann für den Verlauf der mindestens zwei Elektroden gelten.

Ein weiterer Aspekt der vorliegenden Erfindung ist ein elektromechanisches Wandlersystem umfassend eine erste zuvor beschriebene elektromechanische Wandlereinrichtung und mindestens eine mit der ersten elektromechanischen Wandlereinrichtung elektrisch verbindbare zweite zuvor beschriebene elektromechanische Wandlereinrichtung.

Es versteht sich, dass gemäß weiteren Varianten der Erfindung drei oder mehr elektromechanische Wandlereinrichtungen zusammengeschaltet werden können. Bevorzugt kann das mindestens eine

Elektretmaterial der ersten elektromechanischen Wandlereinrichtung eine entgegengesetzte Polarität wie das mindestens eine Elektretmaterial der weiteren elektromechanischen Wandlereinrichtung aufweisen. Beispielsweise kann die erste elektromechanische Wandlereinrichtung mindestens eine Elektretschicht aufweisen, welche positiv geladen ist. Ferner kann die zweite elektromechanische Wandlereinrichtung mindestens eine Elektretschicht aufweisen, welche negativ geladen ist. Bevorzugt kann der Ladungsbetrag der negativen Ladung und der positiven Ladung gleich sein.

Gemäß einer ersten Ausführungsform des erfindungsgemäßen elektromechanischen Wandlersystems kann mindestens eine Elektrode der ersten elektromechanischen Wandlereinrichtung mit mindestens einer ersten Elektrode der zweiten elektromechanischen Wandlereinrichtung elektrisch verbindbar oder verbunden sein. Insbesondere können sämtliche Elektroden der ersten elektromechanischen Wandlereinrichtung mit den entsprechenden Elektroden der zweiten elektromechanischen Wandlereinrichtung über separate elektrische Verbindungen miteinander verbunden sein. Vorzugsweise kann das mindestens eine Elektretmaterial der ersten elektromechanischen Wandlereinrichtung eine im Vergleich zum mindestens einen Elektretmaterial der zweiten elektromechanischen Wandlereinrichtung entgegengesetzte Ladung aufweisen. In einfacher Weise kann eine Ausgleichsladung für die erste bzw. zweite elektromechanische Wandlereinrichtung von der zweiten bzw. ersten elektromechanischen Wandlereinrichtung bereitgestellt werden. Grund hierfür ist, dass die jeweils verbundenen Elektroden einen gleichen Spannungsbetrag mit entgegengesetzter Polarität aufweisen.

Beispielsweise kann eine elektromechanische Wandlereinrichtung oder ein elektromechanisches Wandlersystem in strukturierten Drucksensoren für Tastaturen oder Touchpads, Beschleunigungssensoren, Mikrofonen, Lautsprechern, Ultraschallwandlern für Anwendungen in der Medizintechnik, der Meerestechnik oder zur Materialprüfung verwendet werden.

Ein weiterer Aspekt der vorliegenden Erfindung ist eine Aktorvorrichtung umfassend mindestens eine zuvor beschriebene elektromechanische Wandlereinrichtung. Es versteht sich, dass die Aktorvorrichtung auch zwei oder mehr elektromechanische Wandlereinrichtungen, beispielsweise ein zuvor beschriebenes elektromechanisches System, aufweisen kann. Die Aktorvorrichtung kann darüber hinaus eine Energieversorgung, wie eine Energiequelle, und eine Steuerung zum Steuern der Energiequelle bzw. der elektromechanischen Wandlereinrichtung aufweisen.

Ein weiterer Aspekt der vorliegenden Erfindung ist eine Generatorvorrichtung umfassend mindestens eine zuvor beschriebene elektromechanische Wandlereinrichtung. Es versteht sich, dass die Generatorvorrichtung auch zwei oder mehr elektromechanische Wandlereinrichtungen, beispielsweise ein zuvor beschriebenes elektromechanisches System, aufweisen kann. Die Generatorvorrichtung kann darüber hinaus eine Energieversorgung, wie eine Energiequelle, und eine Steuerung zum Steuern der Energiequelle bzw. der elektromechanischen Wandlereinrichtung aufweisen.

Es versteht sich, dass auch eine Sensorvorrichtung umfassend mindestens eine zuvor beschriebene elektromechanische Wandlereinrichtung vorgesehen sein kann.

Ein noch weiterer Aspekt der vorliegenden Erfindung ist ein Verfahren zum Herstellen einer elektromechanischen Wandlereinrichtung gemäß Anspruch 13.

In einfacher Weise kann eine effizient betreibbare elektromechanische Wandlereinrichtung hergestellt werden. Es versteht sich hierbei, dass die Reihenfolge der Schritte beliebig sein kann. Gemäß einer ersten Ausführungsform des erfindungsgemäßen Verfahrens kann mindestens eine elektroaktive Schicht zumindest teilweise mit einer Elektrode bedruckt werden. Beispielsweise kann eine strukturierte Elektrode aufgedruckt werden. Ein Druckverfahren kann in einfacher Weise durchgeführt werden. Insbesondere ist eine Massenproduktion einer elektromechanischen Wandlereinrichtung mit einer erhöhten Produktionsrate möglich.

Es gibt nun eine Vielzahl von Möglichkeiten, die erfindungsgemäße elektromechanische Wandlereinrichtung, das erfindungsgemäße elektromechanische Wandlersystem, die erfindungsgemäße Aktor- und Generatorvorrichtung sowie das erfindungsgemäße Verfahren zum Herstellen einer elektromechanischen Wandlereinrichtung auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines ersten Ausführungsbeispiels einer elektromechanischen Wandlereinrichtung gemäß der vorliegenden Erfindung;
- Fig. 2: eine schematische Ansicht eines beispielhaften Verlaufs einer Dehnung einer elektroaktiven Schicht in Abhängigkeit eines angelegten elektrischen Felds;
- Fig. 3: eine weitere schematische Ansicht eines weiteren Ausführungsbeispiels einer elektromechanischen Wandlereinrichtung gemäß der vorliegenden Erfindung;
- Fig. 4: eine weitere schematische Ansicht eines weiteren Ausführungsbeispiels einer elektromechanischen Wandlereinrichtung gemäß der vorliegenden Erfindung;
- Fig. 5: eine schematische Ansicht eines Ausführungsbeispiels eines elektromechanischen Wandlersystems gemäß der vorliegenden Erfindung; und
- Fig. 6: ein Flussdiagramm eines Ausführungsbeispiels eines erfindungsgemäßen Verfahrens zum Herstellen einer elektromechanischen Wandlereinrichtung.

Nachfolgend werden gleiche Bezugszeichen für gleiche Elemente verwendet.

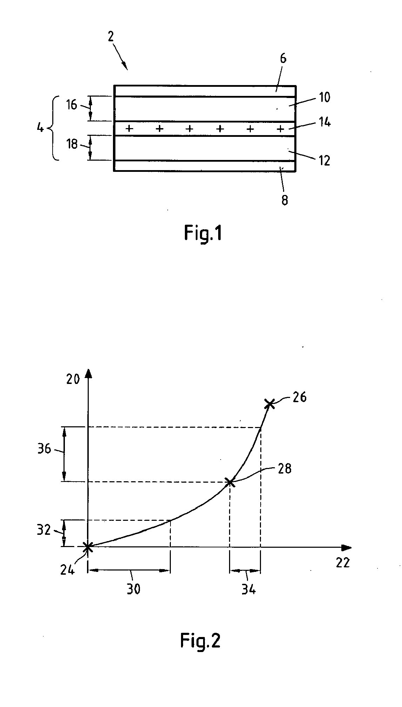

Figur 1 zeigt eine vereinfachte Ansicht, insbesondere Seitenansicht, einer elektromechanischen Wandlereinrichtung 2 gemäß der vorliegenden Erfindung. Die elektromechanische Wandlereinrichtung 2 umfasst einen Schichtverbund 4. Der Schichtverbund 4 ist zwischen einer ersten Elektrode 6 und einer zweiten Elektrode 8 angeordnet.

Die Elektroden 6, 8 können als elektrisch leitfähige Schichten 6, 8 ausgebildet sein. Insbesondere können die Elektroden 6, 8 den Schichtverbund 4 unmittelbar zumindest teilweise kontaktieren. Es versteht sich, dass die Unterseite bzw. die Oberseite des Schichtverbunds 4 nur teilweise mit einer elektrisch leitfähigen Schicht 6, 8 beschichtet sein kann. Beispielsweise kann mindestens eine strukturierte Elektrode 6, 8 aufgedruckt sein.

Vorzugsweise kann eine elektrisch leitfähige Schicht 6, 8 aus einem Material gebildet sein, das ausgewählt ist aus der Gruppe umfassend Metalle, Metalllegierungen, leitfähige Oligo- oder Polymere, leitfähige Oxide, Kohlenstoffnanoröhrchen und/oder mit leitfähigen Füllstoffen gefüllte Polymere.

Der Schichtverbund 4 umfasst im vorliegenden Ausführungsbeispiel drei Schichten 10, 12 und 14, wobei die Schicht 14 zwischen den beiden Schichten 10 und 12 angeordnet ist. Insbesondere kontaktiert die Schicht 14 sowohl die obere Schicht 10 als auch die untere Schicht 12 unmittelbar. Insbesondere ist keine weitere Elektrode zwischen der Schicht 14 und der Schicht 10 bzw. 12 angeordnet.

Dis Schicht 10 ist als eine erste elektroaktive Schicht 10 ausgebildet. Die Schicht 12 ist als eine zweite elektroaktive Schicht 12 ausgebildet. Als elektroaktive Schicht 10, 12 wird eine dielektrische Elastomerschicht 10, 12, wie eine dielektrische Elastomerfolie, eingesetzt. Eine dielektrische Elastomerschicht 10, 12 weist vorteilhafterweise eine relativ hohe Dielektrizitätszahl auf. Darüber hinaus weist eine dielektrische Elastomerschicht 10, 12 vorteilhafterweise eine niedrige mechanische Steifigkeit auf. Dies führt zu möglichen Dehnungswerten von bis zu ca. 300 %. Eine dielektrische Elastomerschicht 10, 12 kann insbesondere für eine Aktoranwendung aber auch für generatorische oder sensorische Anwendungen eingesetzt werden.

Es versteht sich, dass außerhalb der vorliegenden Erfindung auch andere elektroaktiven Schichten verwendet werden können, wie Piezoschichten, elektrostriktive Polymerschichten, flüssigkristalline Elastomerschichten, etc.

Die erste dielelektrische Schicht 10 kann eine erste Dicke 16 aufweisen. Die zweite dielelektrische Schicht 12 kann eine zweite Dicke 18 aufweisen. Die erste Dicke 16 kann im Wesentlichen gleich der zweiten Dicke 18 sein. Es versteht sich, dass eine Dicke 16, 18 einer Schicht 10, 12 über die Fläche unterschiedlich ausgebildet sein kann. Bevorzugt können die beiden sich gegenüber liegenden elektroaktiven Schichten 10 und 12 einen im Wesentlichen gleichen Dickenverlauf aufweisen.

Die Schicht 14 ist im vorliegenden Ausführungsbeispiel eine Elektretschicht 14. Eine Elektretschicht 14 ist zumindest teilweise aus einem Elektretmaterial 14 gebildet. Ein Elektretmaterial 14 weist den Vorteil auf, dass elektrische Ladungen in dem Elektret (permanent) gespeichert werden können. Vor einer Anordnung der Elektretschicht 14 in dem Schichtverbund 4 kann die Elektretschicht 14 beispielsweise elektrisch aufgeladen werden. Es versteht sich, dass die Elektretschicht 14 auch erst nach einer Anordnung der Elektretschicht 14 in dem Schichtverbund 4 aufgeladen werden kann. Zum Beispiel kann das elektrische Aufladen mittels direkter Aufladung oder Coronaentladung durchgeführt werden. Durch die Aufladung weist die Elektretschicht 14 eine vorgebbare dauerhafte Ladung auf. Beispielsweise kann eine positive Ladung mit einem vorgebbaren Wert oder ein negative Ladung mit einem vorgebbaren Wert eingebracht werden. Im vorliegenden Ausführungsbeispiel weist die Elektretschicht 14 positive Ladungen auf.

Es versteht sich, dass das Elektretmaterial 14 gemäß anderen Varianten der Erfindung auch in geeigneter anderer Form, beispielsweise in Form von Fasern und/oder Kugeln, welche zwischen den beiden elektroaktiven Schichten 10, 12 bevorzugt über die Fläche gleichmäßig verteilt angeordnet werden können, bereitgestellt werden kann.

Wie bereits beschrieben wurde, kann die Elektretschicht 14 die beiden dielektrischen Elastomerschichten 10, 12 direkt kontaktieren. Beispielsweise kann die Elektretschicht 14 beidseitig flächig mit den beiden Elastomerschichten 10, 12 verbunden sein. Es versteht sich, dass die Elektretschicht 14 auch nur teilweise mit den beiden Elastomerschichten 10, 12 verbunden sein kann.

Eine Elektretschicht 14, die eine vorgebbare Ladung aufweist, führt dazu, dass sich zwischen der ersten Elektrode 6 und der Elektretschicht 14 ein elektrisches Feld ausbildet. Weiterhin bildet sich aufgrund der Ladung der Elektretschicht 14 ein elektrisches Feld zwischen der zweiten Elektrode 8 und der Elektretschicht 14 aus. Es versteht sich, dass die Elektroden 6, 8 mit einer Ausgleichsspannung verbunden sein können.

Durch die Anordnung eines Elektretmaterials 14, welche eine vorgebbare Ladung aufweist, zwischen zwei elektroaktiven Schichten 10, 12 kann in einfacher Weise beispielsweise bei einer Aktoranwendung die für eine bestimmte Dehnung anzulegende Spannung signifikant reduziert werden. Dies wird nachfolgend anhand der Figur 2 näher erläutert.

Figur 2 zeigt eine schematische Ansicht eines beispielhaften Verlaufs einer Dehnung 20 einer elektroaktiven Schicht in Abhängigkeit eines angelegten elektrischen Feldes 22. Das elektrische Feld 22 hängt unmittelbar mit der an den Elektroden 6, 8 angelegten Spannung U und der Dicke d einer elektroaktiven Schicht 10, 12 gemäß der Formel E=U/d zusammen.

Wie in der Figur 2 zu erkennen ist, verläuft die Kurve näherungsweise quadratisch zwischen einem Ausgangswert 24 und einem Endwert 26. Bei dem Ausgangswert 24 handelt es sich um einen herkömmlichen Arbeitspunkt 24 bei einem elektrischen Feld von 0 V·m⁻¹ und einer entsprechenden Dehnung von 0. Der obere Grenzwert 26 ist die Durchbruchsfeldstärke, welche vom eingesetzten elektroaktiven Material abhängt.

Um eine Dehnung des elektroaktiven Materials ausgehend von dem Arbeitspunkt 24 zu bewirken, kann die angelegte Spannung, also das elektrische Feld 22 von 0 V·m⁻¹, um einen Wert 30 erhöht werden. Die führt zu einer Dehnung 20 um den Wert 32. Zu erkennen ist, dass trotz einer relativ deutlichen Erhöhung des elektrischen Feldes 22 um einen Wert 30 die Dehnung 20 lediglich um einen geringen Wert 32 steigt.

Erfindungsgemäß ist insbesondere erkannt worden, dass der Arbeitspunkt 24 bei einer elektromechanischen Wandlereinrichtung 2 in einfacher Weise beliebig zwischen dem unteren Grenzwert 24 und dem oberen Grenzwert 26 verschoben werden kann. Der Grund hierfür ist, dass die elektromechanische Wandlereinrichtung 2 bereits mit einer (permanenten) Ladung versehen ist. Mit anderen Worten liegt bereits eine Vorspannung an. Die Vorspannung kann gezielt gewählt werden, indem das Elektretmaterial 14 entsprechend aufgeladen wird. Hierdurch verschiebt sich beispielsweise der Arbeitspunkt 24 zum Arbeitspunkt 28.

Wenn ausgehend von dem Arbeitspunkt 28 das elektrische Feld 22 um einen Wert 34, wobei der Wert 34 kleiner als der Wert 30 ist, erhöht wird, ändert sich die Dehnung 20 um einen Wert 36, wobei der Wert 36 größer als der Wert 32 ist. Mit anderen Worten kann bereits durch eine geringe Spannungserhöhung von beispielsweise 10 bis 100 V ausreichend große Dehnungsänderungen erzielt werden.

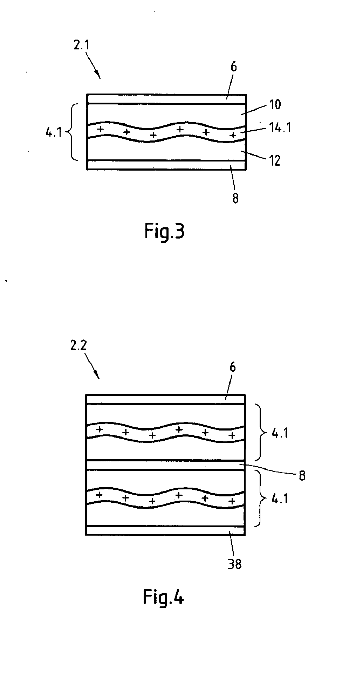

Figur 3 zeigt eine weitere schematische Ansicht, insbesondere eine Seitenansicht, eines weiteren Ausführungsbeispiels einer elektromechanischen Wandlereinrichtung 2.1 mit einem Schichtverbund 4.1 gemäß der vorliegenden Erfindung.

Im Gegensatz zum Ausführungsbeispiel gemäß Figur 1 weist der Schichtverbund 4.1 gemäß Figur 3 eine wellenförmige Elektretschicht 14.1 auf. Eine wellenförmige Elektretschicht 14.1 weist entlang wenigstens einer Richtung ein wellenförmiges Querschnittsprofil auf. Ein wellenförmiges Querschnittsprofil weist insbesondere Erhebungen und Senkungen auf, welche bevorzugt in einer im Wesentlichen gleichmäßigen Abfolge angeordnet sein können. Es versteht sich, dass auch andere Abfolgen vorgesehen sein können, die sich insbesondere an der späteren Anwendung der elektromechanischen Wandlereinrichtung orientieren können.

Ein wellenförmiges Querschnittsprofil kann insbesondere immer dann eingesetzt werden, wenn dass Elektretmaterial 14.1 relativ steif, also nur gering dehnfähig, ausgebildet ist. Um die Dehnfähigkeit eines derartigen Elektretmaterials 14.1 zu erhöhen, kann die Elektretschicht 14.1 ein wellenförmiges Querschnittsprofil aufweisen. Bei einer Dehnung wird das wellenförmige Querschnittsprofil gestreckt und so eine Dehnung in mindestens eine Richtung erhöht.

Ein Beispiel für ein wellenförmiges Profil entlang einer Richtung ist, wenn in einer Elektretschicht 14.1, die eine Dickenrichtung, eine Längsrichtung und eine Querrichtung aufweist, das wellenförmige Profil nur in Längsrichtung gebildet wird. Ein weiteres Beispiel ist der Fall, dass dieses Profil in Längs- und in Querrichtung auftritt. Es versteht sich, dass gemäß anderen Varianten der Erfindung mindestens eine Elektrode 6, 8 ein entsprechendes wellenförmiges Querschnittsprofil aufweisen kann.

Figur 4 zeigt ein weiteres Ausführungsbeispiel einer elektroaktiven Wandlereinrichtung 2.2 gemäß der vorliegenden Erfindung. Das dargestellte Ausführungsbeispiel umfasst einen ersten Schichtverbund 4.1 und einen zweiten Schichtverbund 4.1. Mit anderen Worten sind vorliegend zwei Schichtverbunde 4.1 und 4.1 zu einem Stapel kaskadiert worden.

Der erste und der zweite Schichtverbund 4.1 entsprechen dem Schichtverbund 4.1 gemäß Figur 3. Der Schichtverbund 4.1 ist zwischen einer ersten und einer zweiten Elektrode 6, 8 angeordnet. Im vorliegenden Ausführungsbeispiel ist eine äußere Schicht des weiteren Schichtverbunds 4.1 mit der unteren Elektrode 8 verbunden. An der anderen äußeren Oberfläche ist eine weitere Elektrode 38 angeordnet.

Die Elektretschicht 14.1 des ersten Schichtverbunds 4.1 verläuft im Wesentlichen parallel zur Elektretschicht 14.1 des zweiten Schichtverbunds 4.2. Ferner weisen beide Elektretschichten 14.1 vorzugsweise die gleiche Polarität auf, wobei die Elektretschichten 14.1 im vorliegenden Ausführungsbeispiel beide positiv geladen sind. Darüber hinaus können beide Elektretschichten 14.1 mit dem im Wesentlichen gleichen Ladungsbetrag aufgeladen sein.

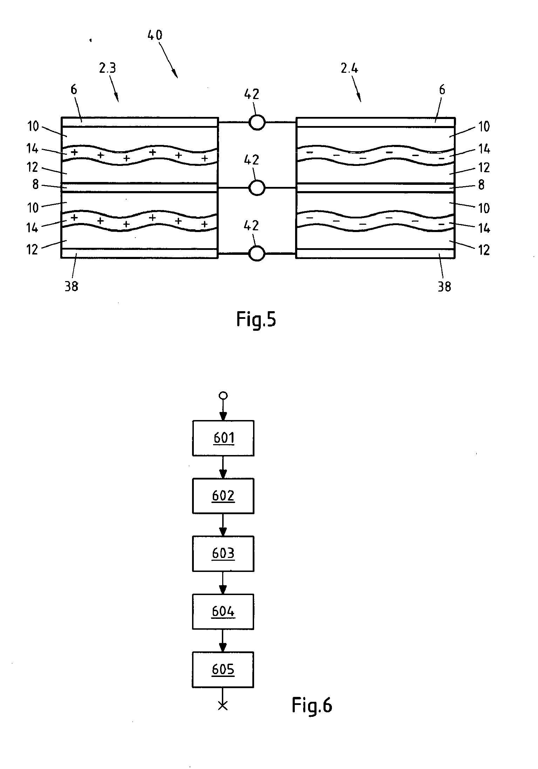

Figur 5 zeigt eine schematische Ansicht eines Ausführungsbeispiels eines elektromechanischen Wandlersystems 40. Das elektromechanische Wandlersystem 40 weist im vorliegenden Ausführungsbeispiel eine erste elektromechanische Wandlereinrichtung 2.3 und eine zweite elektromechanische Wandlereinrichtung 2.4 auf.

Die elektromechanische Wandlereinrichtung 2.3 kann im Wesentlichen der elektromechanischen Wandlereinrichtung 2.2 entsprechen. Auch die elektromechanische Wandlereinrichtung 2.4 kann im Wesentlichen der elektromechanischen Wandlereinrichtung 2.2 entsprechen, wobei im vorliegenden Ausführungsbeispiel die Polarität der Elektretschichten 14 der weiteren elektromechanischen Wandlereinrichtung 2.4 entgegengesetzt zur Polarität der Elektretschichten 14 der ersten elektromechanischen Wandlereinrichtung 2.3 ist. Vorliegend sind die Elektretschichten 14 der ersten elektromechanischen Wandlereinrichtung 2.3 positiv geladen und die Elektretschichten 14 der weiteren elektromechanischen Wandlereinrichtung 2.4 negativ geladen. Bevorzugt können die Ladungsbeträge sämtlicher Elektretschichten 14 des elektromechanischen Wandlersystems 40 im Wesentlichen gleich sein.

Die gleichen Ladungsbeträge mit jedoch unterschiedlicher Polarität führen dazu, dass die jeweiligen Elektroden 6, 8, und 38 eine unterschiedliche Polarität mit einem im Wesentlichen gleichen Ladungsbetrag aufweisen. Vorteilhafterweise können die jeweiligen Elektroden 6, 8, und 38 miteinander elektrisch verbunden sein. In diesem Fall stellt die weitere elektromechanische Wandlereinrichtung 2.4 die Ausgleichsspannung für die erste elektromechanische Wandlereinrichtung 2.3 dar und umgekehrt.

Ferner können steuerbare Energiequellen 42, insbesondere steuerbare Spannungsquellen zwischen den jeweiligen Elektroden 6, 8 und 38 angeordnet sein. Durch eine Änderung der Spannung kann gezielt eine gewünschte Dehnung erzielt werden. Vorzugsweise können mit Spannungsänderung von 100 V, insbesondere von 10 V, ausreichende Dehnungsänderungen erreicht werden.

In Figur 6 ist ein beispielhaftes Flussdiagramm eines Ausführungsbeispiels des erfindungsgemäßen Verfahrens zum Herstellen einer elektromechanischen Wandlereinrichtung, beispielsweise einer elektromechanischen Wandlereinrichtung 2 gemäß Figur 1, abgebildet.

In einem ersten Schritt 601 kann eine erste elektroaktive Schicht 10 bereitgestellt werden. Beispielsweise kann eine dielektrische Elastomerfolie bereitgestellt werden.

In einem nächsten Schritt 602 kann eine erste Elektrode 6 beispielsweise in Form einer elektrisch leitfähigen Schicht 6 auf eine erste Oberfläche der ersten elektroaktiven Schicht 10 aufgebracht werden. Beispielsweise kann die Elektrode 6 flächig oder strukturiert aufgebracht werden. Insbesondere kann die erste elektroaktive Schicht 10 entsprechend bedruckt werden.

Dann kann in einem nächsten Schritt 603 ein eine vorgebbare elektrische Ladung aufweisendes Elektretmaterial 14 auf die zweite Oberfläche der ersten elektroaktiven Schicht 10 aufgebracht werden. Es kann auch vorgesehen sein, dass zunächst Elektretmaterial 14 auf eine elektroaktive Schicht 10 aufgebracht wird kann, und das Elektretmaterial (erst) anschließend, beispielsweise nach Schritt 603 oder auch erst nach Schritt 604 oder 605, aufgeladen wird. Beispielsweise kann das Elektretmaterial 14 durch Beschichten oder Laminieren aufgebracht werden. Insbesondere kann eine Elektretschicht 14 aufgebracht werden.

In einem vorherigen Schritt kann das Elektretmaterial 14 beispielsweise durch Triboaufladung, Elektronenstrahlbeschuss, oder eine Coronaentladung aufgeladen werden, um eine permanente Ladung zu erzeugen. Beispielsweise kann ein Aufladen durch eine so genannte Zweielektronen-Corona-Anordnung durchgeführt werden. Eine Nadelspannung kann mindestens 20 kV, vorzugsweise mindestens 25 kV und insbesondere mindestens 30 kV betragen. Die Aufladezeit kann mindestens 20 s, vorzugsweise mindestens 25 s und insbesondere mindestens 30 s betragen.

Es versteht sich, dass auch zunächst das Elektretmaterial 14 auf eine Oberfläche der ersten elektroaktiven Schicht 10 aufgebracht werden kann und dann erst die erste Elektrode 6. Alternativ können beide Schritte 602 und 603 im Wesentlichen parallel durchgeführt werden.

Des Weiteren kann in einem nächsten Schritt 604 eine zweite elektroaktive Schicht 12 auf das Elektretmaterial 14, welches bereits auf der der ersten elektroaktiven Schicht 10 aufgebracht ist, aufgebracht werden. Wenn eine Elektretschicht 14 vorgesehen ist, kann die gegenüber der Oberfläche, welche mit der ersten elektroaktiven Schicht 10 verbunden ist, liegende Oberfläche mit der weiteren elektroaktiven Schicht 12 beschichtet werden. Auch kann gemäß anderen Varianten der Erfindung zunächst eine Elektretschicht 14 bereitgestellt werden und diese beidseitig mit elektroaktiven Schichten 10, 12 beschichtet werden.

Schließlich kann auf die die zweite elektroaktive Schicht 12 eine zweite Elektrode 8 aufgebracht werden. Mit anderen Worten wird auf die äußere Oberfläche des Schichtverbunds 4 die zweite Elektrode 8 aufgebracht. Es versteht sich auch hier, dass die Elektrode 8 schon zuvor aufgebracht werden kann und beispielsweise eine zweite mit einer Elektrode 8 versehene elektroaktive Schicht 12 bereitgestellt werden kann.

## Patentansprüche

1. Elektromechanische Wandlereinrichtung (2, 2.1, 2.2, 2.3, 2.4), umfassend:
- mindestens einen zwischen einer ersten Elektrode (6) und mindestens einer zweiten Elektrode (8) angeordneten Schichtverbund (4, 4.1),
wobei
- der Schichtverbund (4, 4.1) eine erste elektroaktive Schicht (10) und mindestens eine zweite elektroaktive Schicht (12) aufweist, und
- zwischen der ersten elektroaktiven Schicht (10) und der zweiten elektroaktiven Schicht (12) zumindest abschnittsweise ein Elektretmaterial (14, 14.1) vorhanden ist,
- wobei das Elektretmaterial (14) eine vorgebbare elektrische Ladung aufweist, **dadurch gekennzeichnet, dass** mindestens eine der elektroaktiven Schichten (10, 12) eine dielektrische Elastomerschicht (10, 12) ist.

2. Elektromechanische Wandlereinrichtung (2, 2.1, 2.2, 2.3, 2.4) nach Anspruch 1, **dadurch gekennzeichnet, dass** in Abhängigkeit der elektrischen Ladung des Elektretmaterials (14, 14.1) ein Arbeitspunkt der elektromechanischen Wandlereinrichtung (2, 2.1, 2.2, 2.3, 2.4) einstellbar ist.

3. Elektromechanische Wandlereinrichtung (2, 2.1, 2.2, 2.3, 2.4) nach Anspruch 1 oder 2,
**dadurch gekennzeichnet, dass** das Elektretmaterial (14, 14.1) aus Elektretfasern, Elektretkugeln und/oder einer Elektretschicht (14, 14.1) gebildet ist.

4. Elektromechanische Wandlereinrichtung (2, 2.1, 2.2, 2.3, 2.4) nach einem der Ansprüche 1 bis 3, **dadurch gekennzeichnet, dass** die dielektrische Elastomerschicht (10, 12) ein Material umfasst, das ausgewählt ist aus der Gruppe umfassend Polyurethan-Elastomere, Silikon-Elastomere, Kautschuk-Elastomere (natural rubber and various copolymers) und/oder Acrylat-Elastomere.

5. Elektromechanische Wandlereinrichtung (2, 2.1, 2.2, 2.3, 2.4) nach einem der vorherigen Ansprüche, **dadurch gekennzeichnet, dass** das Elektretmaterial (14, 14.1) ein Material umfasst, das ausgewählt ist aus der Gruppe umfassend Polycarbonat, perfluorierte oder teilfluorierte Polymere und Co-Polymere, Polytetrafluorethylen, Fluorethylenpropylen, Perfluoralkoxyethylen, Polyester, Polyethylenterephthalat, Polyethylennaphthalat, Polyimid, Polyetherimid, Polyether und Polyetherblends (PPE/PS), Polymethyl(meth)acrylat, Cyclo-Olefin-Polymere, Cyclo-Olefin-Copolymere und/oder Polyolefine.

6. Elektromechanische Wandlereinrichtung (2, 2.1, 2.2, 2.3, 2.4) nach einem der vorherigen Ansprüche, **dadurch gekennzeichnet,**
- **dass** die erste elektroaktive Schicht (10) einen ersten Dickenverlauf aufweist, und
- **dass** die zweite elektroaktive Schicht (12) einen zweiten Dickenverlauf aufweist,
- wobei der erste Dickenverlauf im Wesentlichen gleich dem zweiten Dickenverlauf ist.

7. Elektromechanische Wandlereinrichtung (2, 2.1, 2.2, 2.3, 2.4) nach einem der vorherigen Ansprüche, **dadurch gekennzeichnet,**
- **dass** die mindestens eine Elektretschicht (14, 14.1) ein wellenförmiges Querschnittsprofil aufweist,
und/oder
- **dass** mindestens eine Elektrode (6, 8) ein wellenförmiges Querschnittsprofil aufweist.

8. Elektromechanische Wandlereinrichtung (2, 2.1, 2.2, 2.3, 2.4) nach einem der vorherigen Ansprüche, **dadurch gekennzeichnet,**
- **dass** mindestens ein weiterer mit einer weiteren Elektrode (38) versehener Schichtverbund (4, 4.1) vorhanden ist,
- wobei der weitere Schichtverbund (4, 4.1) eine erste elektroaktive Schicht (10) und mindestens eine zweite elektroaktive Schicht (12) aufweist,
- **dass** zwischen der ersten elektroaktiven Schicht (10) und der zweiten elektroaktiven Schicht (12) zumindest abschnittsweise ein Elektretmaterial (14, 14.1) vorhanden ist,
- wobei das Elektretmaterial eine vorgebbare elektrische Ladung aufweist, und
- der Schichtverbund (4, 4.1) mit der ersten Elektrode (6) oder der zweiten Elektrode (8) verbunden ist.

9. Elektromechanisches Wandlersystem (40) umfassend eine erste elektromechanische Wandlereinrichtung (2, 2.1, 2.2, 2.3, 2.4) nach einem der vorherigen Ansprüche und mindestens eine mit der ersten elektromechanischen Wandlereinrichtung (2, 2.1, 2.2, 2.3, 2.4) elektrisch verbindbare zweite elektromechanische Wandlereinrichtung (2, 2.1, 2.2, 2.3, 2.4) nach einem der vorherigen Ansprüche.

10. Elektromechanisches Wandlersystem (40) nach Anspruch 9, **dadurch gekennzeichnet,**
- **dass** mindestens eine Elektrode (6, 8, 38) der ersten elektromechanische Wandlereinrichtung (2, 2.1, 2.2, 2.3, 2.4) mit mindestens einer ersten Elektrode (6, 8, 38) der zweiten elektromechanischen Wandlereinrichtung (2, 2.1, 2.2, 2.3, 2.4) elektrisch verbindbar ist,
- wobei insbesondere das mindestens eine Elektretmaterial (14) der ersten elektromechanischen Wandlereinrichtung (2, 2.1, 2.2, 2.3, 2.4) eine im Vergleich zum mindestens einen Elektretmaterial (14, 14.1) der zweiten elektromechanischen Wandlereinrichtung (2, 2.1, 2.2, 2.3, 2.4) entgegengesetzte Ladung aufweist.

11. Aktorvorrichtung umfassend mindestens eine elektromechanische Wandlereinrichtung (2, 2.1, 2.2, 2.3, 2.4) nach einem der vorherigen Ansprüche 1 bis 8.

12. Generatorvorrichtung umfassend mindestens eine elektromechanische Wandlereinrichtung (2, 2.1, 2.2, 2.3, 2.4) nach einem der vorherigen Ansprüche 1 bis 8.

13. Verfahren zum Herstellen einer elektromechanischen Wandlereinrichtung (2, 2.1, 2.2, 2.3, 2.4), umfassend:
- Bereitstellen einer ersten elektroaktiven Schicht (10),
- Aufbringen einer ersten Elektrode (6) auf eine erste Oberfläche der ersten elektroaktiven Schicht (10),
- Aufbringen eines eine vorgebbare elektrische Ladung aufweisenden oder mit einer vorgebbaren elektrischen Ladung aufladbaren Elektretmaterials (14) auf die zweite Oberfläche der ersten elektroaktiven Schicht (10),
- Aufbringen einer zweiten elektroaktiven Schicht (12) auf das Elektretmaterial (14, 14.1), und
- Aufbringen einer zweiten Elektrode (8) auf die zweite elektroaktiven Schicht (12), **dadurch gekennzeichnet, dass** mindestens eine der elektroaktiven Schichten (10, 12) eine dielektrische Elastomerschicht (10, 12) ist.

14. Verfahren nach Anspruch 13, **dadurch gekennzeichnet, dass** mindestens eine elektroaktive Schicht (10, 12) zumindest teilweise mit einer Elektrode (6, 8, 38) bedruckt wird.

## Claims

1. An electromechanical transducer device (2, 2.1, 2.2, 2.3, 2.4) comprising:
- at least one multilayer composite (4, 4.1) arranged between a first electrode (6) and at least one second electrode (8),
wherein
- the multilayer composite (4, 4.1) has a first electroactive layer (10) and at least one second electroactive layer (12), and
- an electret material (14, 14.1) is provided between the first electroactive layer (10) and the second electroactive layer (12) at least in some places,
- the electret material (14) having a predeterminable electric charge,
**characterized in that** at least one of the electroactive layers (10, 12) is a dielectric elastomer layer (10, 12).

2. The electromechanical transducer device (2, 2.1, 2.2, 2.3, 2.4) as claimed in claim 1, **characterized in that** a working point of the electromechanical transducer device (2, 2.1, 2.2, 2.3,2.4) can be set as a function of the electric charge of the electret material (14, 14.1).

3. The electromechanical transducer device (2, 2.1, 2.2, 2.3, 2.4) as claimed in claim 1 or 2, **characterized in that** the electret material (14, 14.1) is formed of electret fibers, electret balls and/or an electret layer (14, 14.1).

4. The electromechanical transducer device (2, 2.1, 2.2, 2.3,2.4) as claimed in one of the claims 1 to 3, **characterized in that** the dielectric elastomer layer (10, 12) comprises a material that is chosen from the group comprising polyurethane elastomers, silicone elastomers, rubber elastomers (natural rubber and various copolymers) and/or acrylate elastomers.

5. The electromechanical transducer device (2, 2.1, 2.2, 2.3,2.4) as claimed in one of the preceding claims, **characterized in that** the electret material (14, 14.1) comprises a material chosen from the group comprising polycarbonate, perfluorinated or partially fluorinated polymers and copolymers, polytetrafluoroethylene, fluorinated ethylene propylene, perfluoroalkoxy ethylene, polyester, polyethylene terephthalate, polyethylene naphthalate, polyimide, polyetherimide, polyether and polyether blends (PPE/PS), polymethyl (meth)acrylate, cycloolefin polymers, cyclo olefin copolymers and/or polyolefins.

6. The electromechanical transducer device (2, 2.1, 2.2, 2.3,2.4) as claimed in one of the preceding claims, **characterized in that**
- the first electroactive layer (10) has a first thickness profile, and
- the second electroactive layer (12) has a second thickness profile,
- the first thickness profile being essentially the same as the second thickness profile.

7. The electromechanical transducer device (2, 2.1, 2.2, 2.3,2.4) as claimed in one of the preceding claims,
**characterized in that**
- the at least one electret layer (14, 14.1) has a wavelike cross-sectional profile,
and/or
- at least one electrode (6, 8) has a wavelike cross-sectional profile.

8. The electromechanical transducer device (2, 2.1, 2.2, 2.3,2.4) as claimed in one of the preceding claims, **characterized in that**
- at least one further multilayer composite (4, 4.1) provided with a further electrode (38) is present,
- the further multilayer composite (4, 4.1) having a first electroactive layer (10) and at least one second electroactive layer (12),
- an electret material (14, 14.1) is present between the first electroactive layer (10) and the second electroactive layer (12) at least in some places or partially,
- the electret material having a predeterminable electric charge, and
- the multilayer composite (4, 4.1) being connected to the first electrode (6) or the second electrode (8).

9. An electromechanical transducer system (40) comprising a first electromechanical transducer device (2, 2.1, 2.2, 2.3,2.4) as claimed in one of the preceding claims and at least one second transducer device (2, 2.1, 2.2, 2.3, 2.4) as claimed in one of the preceding claims that can be connected electrically to the first electromechanical transducer device (2, 2.1, 2.2, 2.3, 2.4).

10. The electromechanical transducer system (40) as claimed in claim 9, **characterized in that**
- at least one electrode (6, 8, 38) of the first electromechanical transducer device (2, 2.1, 2.2, 2.3, 2.4) can be electrically connected to at least one first electrode (6, 8, 38) of the second electromechanical transducer device (2, 2.1, 2.2, 2.3, 2.4),
- in particular, the at least one electret material (14) of the first electromechanical transducer device (2, 2.1, 2.2, 2.3,2.4) has an opposite charge from that of at least one electret material (14, 14.1) of the second electromechanical transducer device (2, 2.1, 2.2, 2.3, 2.4).

11. An actuator device comprising at least one electromechanical transducer device (2, 2.1, 2.2, 2.3, 2.4) as claimed in one of the preceding claims 1 to 8.

12. A generator device comprising at least one electromechanical transducer device (2, 2.1, 2.2, 2.3, 2.4) as claimed in one of the preceding claims 1 to 8.

13. A method for producing an electromechanical transducer device (2, 2.1, 2.2, 2.3, 2.4), comprising:
- providing a first electroactive layer (10),
- applying a first electrode (6) to a first surface of the first electroactive layer (10),
- applying an electret material (14), which has a predeterminable electric charge or can be charged with a predeterminable electric charge, to the second surface of the first electroactive layer (10),
- applying a second electroactive layer (12) to the electret material (14, 14.1), and
- applying a second electrode (8) to the second electroactive layer (12)
**characterized in that** at least one of the electroactive layers (10, 12) is a dielectric elastomer layer (10, 12).

14. The method as claimed in claim 13, **characterized in that** at least one electroactive layer (10,12) is printed at least partially with an electrode (6, 8, 38).

## Revendications

1. Dispositif convertisseur électromécanique (2, 2.1, 2.2, 2.3, 2.4), comprenant :
- au moins un composite stratifié (4, 4.1) disposé entre une première électrode (6) et au moins une deuxième électrode (8),
où
- le composite stratifié (4, 4.1) comprend une première couche électro-active (10) et au moins une deuxième couche électro-active (12), et où
- un matériau électret (14, 14.1) est au moins partiellement présenté entre la première couche électro-active (10) et la deuxième couche électro-active (12),
- le matériau électret (14) présentant une charge électrique définissable,
**caractérisé**
**en ce qu'**au moins une des couches électro-actives (10, 12) est une couche élastomère diélectrique (10, 12).

2. Dispositif convertisseur électromécanique (2, 2.1, 2.2, 2.3, 2.4) selon la revendication 1, **caractérisé en ce qu'**un point de fonctionnement du dispositif convertisseur électromécanique (2, 2.1, 2.2, 2.3, 2.4) peut être réglé en fonction de la charge électrique du matériau électret (14, 14.1).

3. Dispositif convertisseur électromécanique (2, 2.1, 2.2, 2.3, 2.4) selon la revendication 1 ou la revendication 2, **caractérisé en ce que** le matériau électret (14, 14.1) est formé par des fibres électret, des billes électret et/ou par une couche électret (14, 14.1).

4. Dispositif convertisseur électromécanique (2, 2.1, 2.2, 2.3, 2.4) selon l'une des revendications 1 à 3, **caractérisé en ce que** la couche élastomère diélectrique (10, 12) comprend un matériau sélectionné dans le groupe composé d'élastomères de polyuréthane, d'élastomères de silicone, d'élastomères de caoutchouc (caoutchouc naturel et copolymères divers) et/ou d'élastomères d'acrylate.

5. Dispositif convertisseur électromécanique (2, 2.1, 2.2, 2.3, 2.4) selon l'une des revendications précédentes, **caractérisé en ce que** le matériau électret (14, 14.1) comprend un matériau sélectionné dans le groupe composé de polycarbonate, polymères et copolymères perfluorés ou partiellement fluorés, polytétrafluoréthylène, fluoréthylène propylène, perfluoralcoxyéthylène, polyester, polyéthylène téréphtalate, polyéthylène naphtalate, polyimide, polyétherimide, polyéther et mélanges de polyéther (PPE/PS), polyméthyle(méth)acrylate, cyclo-oléfine-polymères, cyclo-oléfine-copolymères et/ou polyoléfines.

6. Dispositif convertisseur électromécanique (2, 2.1, 22, 2.3, 2.4) selon l'une des revendications précédentes, **caractérisé en ce que** la première couche électro-active (10)
- présente une première épaisseur, et
- **en ce que** la deuxième couche électro-active (12) présente une deuxième épaisseur,
- la première épaisseur étant sensiblement égale à la deuxième épaisseur.

7. Dispositif convertisseur électromécanique (2, 2.1, 2.2, 2.3, 2.4) selon l'une des revendications précédentes, **caractérisé**
- **en ce que** la ou les couches électret (14, 14.1) présentent un profil de section transversale ondulé, et/ou
- **en ce qu'**au moins une électrode (6, 8) présente un profil de section transversale ondulé.

8. Dispositif convertisseur électromécanique (2, 2.1, 2.2, 2.3, 2.4) selon l'une des revendications précédentes, **caractérisé**
- **en ce qu'**au moins un autre composite stratifié (4, 4.1) pourvu d'une autre électrode (38) est présenté,
- ledit autre composite stratifié (4, 4.1) comprenant une première couche électro-active (10) et au moins une deuxième couche électro-active (12),
- **en ce qu'**un matériau électret (14, 14.1) est au moins partiellement présenté entre la première couche électro-active (10) et la deuxième couche électro-active (12),
le matériau électret présentant une charge électrique définissable, et
- **en ce que** le composite stratifié (4, 4.1) est relié à la première électrode (6) ou à la deuxième électrode (8).

9. Système convertisseur électromécanique (40) comprenant un premier dispositif convertisseur électromécanique (2, 2.1, 2.2, 2.3, 2.4) selon l'une des revendications précédentes et au moins un deuxième dispositif convertisseur électromécanique (2, 2.1, 2.2, 2.3, 2.4) selon l'une des revendications précédentes pouvant être électriquement relié au premier dispositif convertisseur électromécanique (2, 2.1, 2.2, 2.3, 2.4).

10. Système convertisseur électromécanique (40) selon la revendication 9, **caractérisé en ce qu'**au moins une électrode (6, 8, 38) du premier dispositif convertisseur électromécanique (2, 2.1, 2.2, 2.3, 2.4) peut être électriquement reliée à au moins une première électrode (6, 8, 38) du deuxième dispositif convertisseur électromécanique (2, 2.1, 2.2, 2.3, 2.4),
le ou les matériaux électrets (14) du premier dispositif convertisseur électromécanique (2, 2.1, 2.2, 2.3, 2.4) présentant en particulier une charge contraire par rapport à au moins un matériau électret (14, 14.1) du deuxième dispositif convertisseur électromécanique (2, 2.1, 2.2, 2.3, 2.4).

11. Dispositif actionneur comprenant au moins un dispositif convertisseur électromécanique (2, 2.1, 2.2, 2.3, 2.4) selon l'une des revendications 1 à 8.

12. Dispositif générateur comprenant au moins un dispositif convertisseur électromécanique (2, 2.1, 2.2, 2.3, 2.4) selon l'une des revendications 1 à 8.

13. Procédé de fabrication d'un dispositif convertisseur électromécanique (2, 2.1, 2.2, 2.3, 2.4), comprenant:
- la préparation d'une première couche électro-active (10),
- l'application d'une première électrode (6) sur une première surface de la première couche électro-active (10),
- l'application d'un matériau électret (14) présentant une charge électrique définissable ou pouvant être chargé avec une charge électrique définissable sur la deuxième surface de la première couche électro-active (10),
- l'application d'une deuxième couche électro-active (12) sur le matériau électret (14, 14.1), et
- l'application d'une deuxième électrode (8) sur la deuxième couche électro-active (12),
**caractérisé**
**en ce qu'**au moins une couche électro-active (10, 12) est une couche élastomère diélectrique (10, 12).

14. Procédé selon la revendication 13, **caractérisé en ce qu'**au moins une couche électro-active (10, 12) est au moins partiellement imprimée avec une électrode (6, 8, 38).
